# EUROPEAN PATENT APPLICATION

(11) **EP 4 300 834 A1**
(43) Date of publication of application: **03.01.2024**
(21) Application number: 21932229.4
(22) Date of filing: 25.03.2021
(51) Int. Cl.: H04B 1/403

(54) **MULTI-CHIP APPARATUS AND ELECTRONIC DEVICE**

(71) Applicant: Huawei Technologies Co., Ltd., Shenzhen, Guangdong 518129 (CN)
(72) Inventor: DING, Bowen, Shenzhen, Guangdong 518129 (CN); CUI, Keji, Shenzhen, Guangdong 518129 (CN); GUO, Wanyi, Shenzhen, Guangdong 518129 (CN)
(74) Representative: MERH-IP Matias Erny Reichl Hoffmann Patentanwälte PartG mbB
(86) International application number: PCT/CN2021/083110
(87) International publication number: WO 2022/198604

(57) **Abstract**

Embodiments of this application relate to the chip field, and disclose a multi-chip apparatus and an electronic device, to improve phased array performance. A specific solution is as follows: The multi-chip apparatus includes a first chip with a first internal signal generator and a first frequency multiplier, and a second chip with a second internal signal generator and a second frequency multiplier. The second frequency multiplier includes a first receiving circuit, a second receiving circuit, and a load circuit, an input end of the first receiving circuit is coupled to an output end of the first internal signal generator, an input end of the second receiving circuit is coupled to an output end of the second internal signal generator, and an output end of the first receiving circuit and an output end of the second receiving circuit are coupled to an input end of the load circuit. The second frequency multiplier is configured to receive, by using the first receiving circuit, a first local oscillator signal generated by the first internal signal generator, receive, by using the second receiving circuit, a second local oscillator signal generated by the second internal signal generator, and perform frequency multiplication on the first local oscillator signal or the second local oscillator signal.

## Description

### TECHNICAL FIELD

Embodiments of this application relate to the chip field, and in particular, to a multi-chip apparatus and an electronic device.

### BACKGROUND

An operating band of 5th generation (5th generation, 5G) mobile communication is a millimeter-wave band. The millimeter-wave band has abundant spectrum resources and a relatively wide operating bandwidth, but a propagation loss is high. To reduce a transmission loss in a millimeter-wave communication process, a phased array beamforming technology may be used to improve a signal gain. In addition to the 5G millimeter-wave band, phased arrays are increasingly widely used in fields such as indoor communication and vehicle communication.

However, in a conventional technology, phased array performance is limited, which affects quality of wireless communication. Therefore, how to achieve higher phased array performance becomes an urgent problem to be resolved.

### SUMMARY

Embodiments of this application provide a multi-chip apparatus and an electronic device, to improve phased array performance.

To achieve the foregoing objective, the following technical solutions are used in embodiments of this application:

According to a first aspect, an embodiment of this application provides a multi-chip apparatus. The multi-chip apparatus includes a first chip and a second chip, the first chip includes a first internal signal generator and a first frequency multiplier coupled to the first internal signal generator, the second chip includes a second frequency multiplier, and the second frequency multiplier is coupled to the first internal signal generator through an input/output pin between the first chip and the second chip. The first internal signal generator is configured to generate a first local oscillator signal. The first frequency multiplier and the second frequency multiplier are configured to receive the first local oscillator signal, and perform frequency multiplication on the first local oscillator signal. According to this solution, the first local oscillator signal generated by the first internal signal generator may be input to the first frequency multiplier, and may also be input to the second frequency multiplier through the input/output pin between the first chip and the second chip. That is, both a local oscillator signal of the first chip and a local oscillator signal of the second chip come from the first internal signal generator. Therefore, signal sources of the local oscillator signals of the first chip and the second chip are the same. When the first chip and the second chip are cascaded to form a phased array, signals of the first chip and the second chip can be superimposed, to improve a phased array gain.

With reference to the first aspect, in a possible implementation, the multi-chip apparatus further includes a power splitter, the power splitter includes a first output end and a second output end, an input end of the power splitter is coupled to an output end of the first internal signal generator, and the first output end and the second output end of the power splitter are respectively coupled to the first frequency multiplier and the second frequency multiplier. According to this solution, the power splitter is disposed in the multi-chip apparatus, so that a signal path of a first local oscillator signal input to the first frequency multiplier is exactly the same as that of a first local oscillator signal input to the second frequency multiplier. Therefore, a phase, an amplitude, and a frequency of the local oscillator signal of the first chip are all the same as those of the local oscillator signal of the second chip, and phase alignment between the first chip and the second chip can be ensured.

With reference to the first aspect and the foregoing possible implementation, in another possible implementation, the first chip further includes an output driver, the output driver is coupled to the output end of the first internal signal generator, and the output driver is configured to amplify the first local oscillator signal. According to this solution, the first local oscillator signal in the first chip may be amplified by using the output driver, and externally input to the second chip, so that signal sources of local oscillator signals of the first chip and the second chip are the same. Optionally, the first local oscillator signal input to the output driver may be differential signals, and the first local oscillator signal output by the output driver may be a single-ended signal.

With reference to the first aspect and the foregoing possible implementation, in another possible implementation, the second chip further includes a second internal signal generator, and the second internal signal generator is coupled to the second frequency multiplier. The second internal signal generator is configured to generate a second local oscillator signal. The second frequency multiplier is further configured to receive the second local oscillator signal, and perform frequency multiplication on the second local oscillator signal. According to this solution, the second frequency multiplier may be configured to receive the first local oscillator signal, and may also be configured to receive the second local oscillator signal. In other words, the second frequency multiplier supports both an internal signal input (the second local oscillator signal) and an external signal input (the first local oscillator signal). Therefore, when receiving the first local oscillator signal, the second frequency multiplier may perform frequency multiplication on the first local oscillator signal. When receiving the second local oscillator signal, the second frequency multiplier may perform frequency multiplication on the second local oscillator signal.

With reference to the first aspect and the foregoing possible implementation, in another possible implementation, the second chip further includes a selector, and the second internal signal generator is coupled to the second frequency multiplier through the selector. The second frequency multiplier is configured to selectively receive the first local oscillator signal and the second local oscillator signal through the selector. According to this solution, the second frequency multiplier may selectively receive an internal signal input and an external signal input through the selector, and then perform frequency multiplication on a received signal. In this implementation, the selector and the frequency multiplier in the second chip are two stages of circuits.

With reference to the first aspect and the foregoing possible implementation, in another possible implementation, the second frequency multiplier includes a first receiving circuit, a second receiving circuit, and a load circuit, an input end of the first receiving circuit is coupled to the first internal signal generator through the input/output pin between the first chip and the second chip, an input end of the second receiving circuit is coupled to the second internal signal generator, and an output end of the first receiving circuit and an output end of the second receiving circuit are coupled to an input end of the load circuit. The first receiving circuit is configured to receive the first local oscillator signal, and the second receiving circuit is configured to receive the second local oscillator signal. According to this solution, the second frequency multiplier may selectively receive the first local oscillator signal and the second local oscillator signal by using the first receiving circuit and the second receiving circuit in the frequency multiplier. In this implementation, the second chip can implement a selection function and a frequency multiplication function by using only the second frequency multiplier. Compared with the previous implementation in which the second chip needs to implement the selection and frequency multiplication functions by using two stages of circuits: a selector and a frequency multiplier, this implementation can reduce an area of the chip, and reduce power consumption of the chip.

With reference to the first aspect and the foregoing possible implementation, in another possible implementation, the first receiving circuit includes a conversion circuit and a first differential circuit, an input end of the conversion circuit is an input end of the first receiving circuit, two output ends of the conversion circuit are respectively coupled to input ends of the first differential circuit, and output ends of the first differential circuit are output ends of the first receiving circuit. The conversion circuit is configured to convert the input first local oscillator signal into differential signals. The differential circuit is configured to receive the differential signals, and output the differential signals to the load circuit. According to this solution, the first local oscillator signal may be converted into the differential signals by using the conversion circuit, and then the differential signals are input to the differential circuit, to implement a receiving function. Optionally, an output signal of the first differential circuit may be a single-ended signal, or may be differential signals.

With reference to the first aspect and the foregoing possible implementation, in another possible implementation, the first differential circuit includes a first metal-oxide-semiconductor MOS transistor and a second MOS transistor, a first end of the first MOS transistor and a first end of the second MOS transistor are input ends of the first differential circuit, a second end of the first MOS transistor and a second end of the second MOS transistor are grounded or connected to a first power supply, and a third end of the first MOS transistor and a third end of the second MOS transistor are output ends of the first receiving circuit. According to this solution, the differential signals output by the conversion circuit may be input to a pair of differential pair transistors, to implement a receiving function.

With reference to the first aspect and the foregoing possible implementation, in another possible implementation, the first MOS transistor and the second MOS transistor are N-type MOS transistors, the first end of the first MOS transistor is a gate, the second end of the first MOS transistor is a source, the third end of the first MOS transistor is a drain, the first end of the second MOS transistor is a gate, the second end of the second MOS transistor is a source, the third end of the second MOS transistor is a drain, and the source of the first MOS transistor and the source of the second MOS transistor are grounded. According to this solution, the first differential circuit may include two N-type MOS transistors. After the differential signals output by the conversion circuit are input to the differential circuit including the two N-type MOS transistors, a receiving function may be implemented, and a loss is relatively low.

With reference to the first aspect and the foregoing possible implementation, in another possible implementation, the conversion circuit includes a first transformer, one end of a primary coil of the first transformer is an input end of the first receiving circuit, a second end of the primary coil of the first transformer is grounded, and two ends of a secondary coil of the first transformer are two output ends of the conversion circuit. According to this solution, a single-ended signal may be converted into differential signals by using the transformer, and the differential signals are input to a pair of differential pair transistors, to implement a receiving function.

With reference to the first aspect and the foregoing possible implementation, in another possible implementation, the second receiving circuit includes a second differential circuit, and the second differential circuit is configured to receive the second local oscillator signal, and output the second local oscillator signal to the load circuit. According to this solution, the second local oscillator signal is received by using a differential circuit, so that an output signal of the second receiving circuit may be a single-ended signal, or may be differential signals.

With reference to the first aspect and the foregoing possible implementation, in another possible implementation, the second differential circuit includes a third MOS transistor and a fourth MOS transistor, a first end of the third MOS transistor and a first end of the fourth MOS transistor are two input ends of the second receiving circuit, a second end of the third MOS transistor and a second end of the fourth MOS transistor are grounded or connected to a second power supply, and a third end of the third MOS transistor and a third end of the fourth MOS transistor are output ends of the second receiving circuit. According to this solution, the second local oscillator signal is received by using a pair of differential pair transistors, so that an output signal of the second receiving circuit may be a single-ended signal, or may be differential signals.

With reference to the first aspect and the foregoing possible implementation, in another possible implementation, the third MOS transistor and the fourth MOS transistor are N-type MOS transistors, the first end of the third MOS transistor is a gate, the second end of the third MOS transistor is a source, the third end of the third MOS transistor is a drain, the first end of the fourth MOS transistor is a gate, the second end of the fourth MOS transistor is a source, the third end of the fourth MOS transistor is a drain, and the source of the third MOS transistor and the source of the fourth MOS transistor are grounded. According to this solution, the second differential circuit may include two N-type MOS transistors. After the second local oscillator signal is input to the differential circuit including the two N-type MOS transistors, a receiving function may be implemented, and a loss is relatively low.

With reference to the first aspect and the foregoing possible implementation, in another possible implementation, the load circuit includes a second transformer, one end of a primary coil of the second transformer is connected to a third power supply, the other end of the primary coil of the second transformer is an input end of the load circuit, and two ends of a secondary coil of the first transformer are output ends of the load circuit. According to this solution, both the first receiving circuit and the second receiving circuit include a pair of differential pair transistors. Therefore, when the first receiving circuit receives the first local oscillator signal or the second receiving circuit receives the second local oscillator signal, corresponding differential pair transistors are on alternately, so that a frequency of the signal is doubled, and after the second transformer converts a single-ended signal into differential signals, a double-frequency signal is output.

With reference to the first aspect and the foregoing possible implementation, in another possible implementation, the load circuit includes a third transformer and a fifth MOS transistor, one end of a primary coil of the third transformer is coupled to a fourth power supply and a first end of the fifth MOS transistor, the other end of the primary coil of the third transformer is coupled to a third end of the fifth MOS transistor, a second end of the fifth MOS transistor is an input end of the load circuit, and two ends of a secondary coil of the third transformer are output ends of the load circuit. According to this solution, both the first receiving circuit and the second receiving circuit include a pair of differential pair transistors. Therefore, when the first receiving circuit receives the first local oscillator signal or the second receiving circuit receives the second local oscillator signal, corresponding differential pair transistors are on alternately to drive the single-ended cascode transistor M5, and after the third transformer converts a single-ended signal into differential signals, a double-frequency signal is output.

With reference to the first aspect and the foregoing possible implementation, in another possible implementation, the fifth MOS transistor is an N-type MOS transistor, the first end of the fifth MOS transistor is a gate, the second end of the fifth MOS transistor is a source, the third end of the fifth MOS transistor is a drain, and the source of the fifth MOS transistor is grounded. According to this solution, both the first receiving circuit and the second receiving circuit include a pair of differential pair transistors. Therefore, when the first receiving circuit receives the first local oscillator signal or the second receiving circuit receives the second local oscillator signal, corresponding differential pair transistors are on alternately to drive the single-ended cascode transistor M5, and after the third transformer converts a single-ended signal into differential signals, a double-frequency signal is output.

Optionally, the load circuit may be an oscillation circuit, and a specific circuit structure of the oscillation circuit is not limited in this solution. When the load circuit is an oscillation circuit, a resonance frequency of the oscillation circuit may be n times a frequency of the first local oscillator signal or a frequency of the second local oscillator signal. The oscillation circuit is configured to multiply the frequency of the first local oscillator signal or the frequency of the second local oscillator signal by n, where n may be an odd number greater than 1. A specific circuit structure of the oscillation circuit is not limited in this embodiment of this application.

With reference to the first aspect and the foregoing possible implementation, in another possible implementation, the load circuit includes a sixth MOS transistor, a seventh MOS transistor, and a first LC circuit, a first end of the sixth MOS transistor is coupled to a third end of the seventh MOS transistor, a second end of the sixth MOS transistor and a second end of the seventh MOS transistor are grounded or connected to a fifth power supply, a third end of the sixth MOS transistor is coupled to a first end of the seventh MOS transistor, and the first end of the sixth MOS transistor and the first end of the seventh MOS transistor are respectively two input ends of the load circuit; and two input ends of the first LC circuit are coupled to a sixth power supply, two output ends of the first LC circuit are respectively coupled to the third end of the sixth MOS transistor and the third end of the seventh MOS transistor, and the two output ends of the first LC circuit are output ends of the load circuit. According to this solution, both the first receiving circuit and the second receiving circuit include a pair of differential pair transistors. Therefore, when the first receiving circuit receives the first local oscillator signal or the second receiving circuit receives the second local oscillator signal, high-order odd differential current signals generated by differential pair transistors non-linearly are injected into a negative-resistance resonant cavity including the sixth MOS transistor, the seventh MOS transistor, and the first LC circuit, and the resonant cavity performs resonant amplification on the high-order odd signals to implement a frequency multiplication output.

With reference to the first aspect and the foregoing possible implementation, in another possible implementation, the sixth MOS transistor and the seventh MOS transistor are N-type MOS transistors, the first end of the sixth MOS transistor is a gate, the second end of the sixth MOS transistor is a source, the third end of the sixth MOS transistor is a drain, the first end of the seventh MOS transistor is a gate, the second end of the seventh MOS transistor is a source, the third end of the seventh MOS transistor is a drain, and the source of the sixth MOS transistor and the source of the seventh MOS transistor are grounded. According to this solution, the two MOS transistors in the load circuit are two N-type MOS transistors. Because the NMOS transistors have a relatively low loss, the load circuit has a relatively low loss.

With reference to the first aspect and the foregoing possible implementation, in another possible implementation, the first LC circuit is a transformer. According to this solution, the first LC circuit in the load circuit may be replaced with a transformer, to implement a frequency multiplication output. Optionally, the first LC circuit may alternatively include an inductor and a capacitor, or may be in another form. A specific circuit structure of the first LC circuit is not limited in this solution.

With reference to the first aspect and the foregoing possible implementation, in another possible implementation, the load circuit includes an eighth MOS transistor, a ninth MOS transistor, and a second LC circuit, a first end of the eighth MOS transistor is coupled to a third end of the ninth MOS transistor, a third end of the eighth MOS transistor is coupled to a first end of the ninth MOS transistor, and a second end of the eighth MOS transistor and a second end of the ninth MOS transistor are respectively two input ends of the load circuit; and two input ends of the second LC circuit are coupled to a seventh power supply, two output ends of the second LC circuit are respectively coupled to the third end of the eighth MOS transistor and the third end of the ninth MOS transistor, and the two output ends of the second LC circuit are output ends of the load circuit. According to this solution, both the first receiving circuit and the second receiving circuit include a pair of differential pair transistors. Therefore, when the first receiving circuit receives the first local oscillator signal or the second receiving circuit receives the second local oscillator signal, high-order odd differential current signals generated by differential pair transistors non-linearly are injected into a negative-resistance resonant cavity including the eighth MOS transistor, the ninth MOS transistor, and the second LC circuit, and the resonant cavity performs resonant amplification on the high-order odd signals to implement a frequency multiplication output.

With reference to the first aspect and the foregoing possible implementation, in another possible implementation, the eighth MOS transistor and the ninth MOS transistor are N-type MOS transistors, the first end of the eighth MOS transistor is a gate, the second end of the eighth MOS transistor is a source, the third end of the eighth MOS transistor is a drain, the first end of the ninth MOS transistor is a gate, the second end of the ninth MOS transistor is a source, the third end of the ninth MOS transistor is a drain, and the source of the eighth MOS transistor and the source of the ninth MOS transistor are grounded. According to this solution, the two MOS transistors in the load circuit are two N-type MOS transistors. Because the NMOS transistors have a relatively low loss, the load circuit has a relatively low loss.

With reference to the first aspect and the foregoing possible implementation, in another possible implementation, the second LC circuit is a transformer. According to this solution, the second LC circuit in the load circuit may be replaced with a transformer, to implement a frequency multiplication output. Optionally, the second LC circuit may alternatively include an inductor and a capacitor, or may be in another form. A specific circuit structure of the second LC circuit is not limited in this solution.

With reference to the first aspect and the foregoing possible implementation, in another possible implementation, a resonance frequency of the load circuit is n times a frequency of the first local oscillator signal or a frequency of the second local oscillator signal, and n is an odd number greater than 1. According to this solution, a frequency multiplication output of the frequency multiplier may be implemented by setting the resonance frequency in the load circuit.

With reference to the first aspect and the foregoing possible implementation, in another possible implementation, the first chip further includes a plurality of first phased array channels and a first frequency mixer, and the plurality of first phased array channels are coupled to the first frequency multiplier through the first frequency mixer; and the second chip further includes a plurality of second phased array channels and a second frequency mixer, and the plurality of second phased array channels are coupled to the second frequency multiplier through the second frequency mixer. According to this solution, the second frequency multiplier may selectively receive the first local oscillator signal and the second local oscillator signal by using the first receiving circuit and the second receiving circuit in the second frequency multiplier. Therefore, an area of the chip can be reduced, and power consumption of the chip can be reduced.

According to a second aspect, an embodiment of this application provides a frequency multiplier. The frequency multiplier includes a first receiving circuit, a second receiving circuit, and a load circuit, an input end of the first receiving circuit is configured to receive a first local oscillator signal, an input end of the second receiving circuit is configured to receive a second local oscillator signal, and an output end of the first receiving circuit and an output end of the second receiving circuit are coupled to an input end of the load circuit.

With reference to the second aspect, in a possible implementation, the first receiving circuit includes a conversion circuit and a first differential circuit, an input end of the conversion circuit is an input end of the first receiving circuit, two output ends of the conversion circuit are respectively coupled to input ends of the first differential circuit, and output ends of the first differential circuit are output ends of the first receiving circuit. The conversion circuit is configured to convert the input first local oscillator signal into differential signals. The differential circuit is configured to receive the differential signals, and output the differential signals to the load circuit.

With reference to the second aspect and the foregoing possible implementation, in another possible implementation, the first differential circuit includes a first metal-oxide-semiconductor MOS transistor and a second MOS transistor, a first end of the first MOS transistor and a first end of the second MOS transistor are input ends of the first differential circuit, a second end of the first MOS transistor and a second end of the second MOS transistor are grounded or connected to a first power supply, and a third end of the first MOS transistor and a third end of the second MOS transistor are output ends of the first receiving circuit.

With reference to the second aspect and the foregoing possible implementation, in another possible implementation, the first MOS transistor and the second MOS transistor are N-type MOS transistors, the first end of the first MOS transistor is a gate, the second end of the first MOS transistor is a source, the third end of the first MOS transistor is a drain, the first end of the second MOS transistor is a gate, the second end of the second MOS transistor is a source, the third end of the second MOS transistor is a drain, and the source of the first MOS transistor and the source of the second MOS transistor are grounded.

With reference to the second aspect and the foregoing possible implementation, in another possible implementation, the conversion circuit includes a first transformer, one end of a primary coil of the first transformer is an input end of the first receiving circuit, a second end of the primary coil of the first transformer is grounded, and two ends of a secondary coil of the first transformer are two output ends of the conversion circuit.

With reference to the second aspect and the foregoing possible implementation, in another possible implementation, the second receiving circuit includes a second differential circuit, and the second differential circuit is configured to receive the second local oscillator signal, and output the second local oscillator signal to the load circuit.

With reference to the second aspect and the foregoing possible implementation, in another possible implementation, the second differential circuit includes a third MOS transistor and a fourth MOS transistor, a first end of the third MOS transistor and a first end of the fourth MOS transistor are two input ends of the second receiving circuit, a second end of the third MOS transistor and a second end of the fourth MOS transistor are grounded or connected to a second power supply, and a third end of the third MOS transistor and a third end of the fourth MOS transistor are output ends of the second receiving circuit.

With reference to the second aspect and the foregoing possible implementation, in another possible implementation, the third MOS transistor and the fourth MOS transistor are N-type MOS transistors, the first end of the third MOS transistor is a gate, the second end of the third MOS transistor is a source, the third end of the third MOS transistor is a drain, the first end of the fourth MOS transistor is a gate, the second end of the fourth MOS transistor is a source, the third end of the fourth MOS transistor is a drain, and the source of the third MOS transistor and the source of the fourth MOS transistor are grounded.

With reference to the second aspect and the foregoing possible implementation, in another possible implementation, the load circuit includes a second transformer, one end of a primary coil of the second transformer is connected to a third power supply, the other end of the primary coil of the second transformer is an input end of the load circuit, and two ends of a secondary coil of the first transformer are output ends of the load circuit.

With reference to the second aspect and the foregoing possible implementation, in another possible implementation, the load circuit includes a third transformer and a fifth MOS transistor, one end of a primary coil of the third transformer is coupled to a fourth power supply and a first end of the fifth MOS transistor, the other end of the primary coil of the third transformer is coupled to a third end of the fifth MOS transistor, a second end of the fifth MOS transistor is an input end of the load circuit, and two ends of a secondary coil of the third transformer are output ends of the load circuit.

With reference to the second aspect and the foregoing possible implementation, in another possible implementation, the fifth MOS transistor is an N-type MOS transistor, the first end of the fifth MOS transistor is a gate, the second end of the fifth MOS transistor is a source, the third end of the fifth MOS transistor is a drain, and the source of the fifth MOS transistor is grounded.

With reference to the second aspect and the foregoing possible implementation, in another possible implementation, the load circuit includes a sixth MOS transistor, a seventh MOS transistor, and a first LC circuit, a first end of the sixth MOS transistor is coupled to a third end of the seventh MOS transistor, a second end of the sixth MOS transistor and a second end of the seventh MOS transistor are grounded or connected to a fifth power supply, a third end of the sixth MOS transistor is coupled to a first end of the seventh MOS transistor, and the first end of the sixth MOS transistor and the first end of the seventh MOS transistor are respectively two input ends of the load circuit; and two input ends of the first LC circuit are coupled to a sixth power supply, two output ends of the first LC circuit are respectively coupled to the third end of the sixth MOS transistor and the third end of the seventh MOS transistor, and the two output ends of the first LC circuit are output ends of the load circuit.

With reference to the second aspect and the foregoing possible implementation, in another possible implementation, the sixth MOS transistor and the seventh MOS transistor are N-type MOS transistors, the first end of the sixth MOS transistor is a gate, the second end of the sixth MOS transistor is a source, the third end of the sixth MOS transistor is a drain, the first end of the seventh MOS transistor is a gate, the second end of the seventh MOS transistor is a source, the third end of the seventh MOS transistor is a drain, and the source of the sixth MOS transistor and the source of the seventh MOS transistor are grounded.

With reference to the second aspect and the foregoing possible implementation, in another possible implementation, the first LC circuit is a transformer.

With reference to the second aspect and the foregoing possible implementation, in another possible implementation, the load circuit includes an eighth MOS transistor, a ninth MOS transistor, and a second LC circuit, a first end of the eighth MOS transistor is coupled to a third end of the ninth MOS transistor, a third end of the eighth MOS transistor is coupled to a first end of the ninth MOS transistor, and a second end of the eighth MOS transistor and a second end of the ninth MOS transistor are respectively two input ends of the load circuit; and two input ends of the second LC circuit are coupled to a seventh power supply, two output ends of the second LC circuit are respectively coupled to the third end of the eighth MOS transistor and the third end of the ninth MOS transistor, and the two output ends of the second LC circuit are output ends of the load circuit.

With reference to the second aspect and the foregoing possible implementation, in another possible implementation, the eighth MOS transistor and the ninth MOS transistor are N-type MOS transistors, the first end of the eighth MOS transistor is a gate, the second end of the eighth MOS transistor is a source, the third end of the eighth MOS transistor is a drain, the first end of the ninth MOS transistor is a gate, the second end of the ninth MOS transistor is a source, the third end of the ninth MOS transistor is a drain, and the source of the eighth MOS transistor and the source of the ninth MOS transistor are grounded.

With reference to the second aspect and the foregoing possible implementation, in another possible implementation, the second LC circuit is a transformer.

With reference to the second aspect and the foregoing possible implementation, in another possible implementation, a resonance frequency of the load circuit is n times a frequency of the first local oscillator signal or a frequency of the second local oscillator signal, and n is an odd number greater than 1.

For effect descriptions of the second aspect, refer to the effect descriptions of the first aspect. Details are not described herein again.

According to a third aspect, an embodiment of this application provides a communication apparatus. The communication apparatus includes the first chip according to any implementation of the first aspect, the second chip according to any implementation of the first aspect, a plurality of first antenna units, and a plurality of second antenna units. The plurality of first antenna units are coupled to the plurality of first phased array channels one by one, and the plurality of second antenna units are coupled to the plurality of second phased array channels one by one.

According to a fourth aspect, an embodiment of this application provides an electronic device. The electronic device includes a baseband chip and the multi-chip apparatus according to any implementation of the first aspect.

### BRIEF DESCRIPTION OF DRAWINGS

FIG. 1 is a schematic diagram of a structure of phased array beamforming according to an embodiment of this application;
FIG. 2(a) and FIG. 2(b) are schematic diagrams of a cascaded structure of a plurality of chips according to an embodiment of this application;
FIG. 3 is a schematic diagram of a structure of a multi-chip apparatus according to an embodiment of this application;
FIG. 4 is a schematic diagram of a structure of another multi-chip apparatus according to an embodiment of this application;
FIG. 5A is a schematic diagram of a structure of another multi-chip apparatus according to an embodiment of this application;
FIG. 5B is a schematic diagram of a structure of another multi-chip apparatus according to an embodiment of this application;
FIG. 6 is a schematic diagram of a circuit structure of a second frequency multiplier according to an embodiment of this application;
FIG. 7 is a schematic diagram of a circuit structure of another second frequency multiplier according to an embodiment of this application;
FIG. 8 is a schematic diagram of a circuit structure of another second frequency multiplier according to an embodiment of this application;
FIG. 9 is a schematic diagram of a circuit structure of another second frequency multiplier according to an embodiment of this application;
FIG. 10 is a schematic diagram of a structure of another multi-chip apparatus according to an embodiment of this application;
FIG. 11 is a schematic diagram of a circuit structure of a selector according to an embodiment of this application;
FIG. 12 is a schematic diagram of a circuit structure of another second frequency multiplier according to an embodiment of this application;
FIG. 13 is a schematic diagram of a circuit structure of another second frequency multiplier according to an embodiment of this application; and
FIG. 14 is a schematic diagram of a structure of another multi-chip apparatus according to an embodiment of this application.

### DESCRIPTION OF EMBODIMENTS

The following describes technical solutions in embodiments of this application with reference to accompanying drawings in embodiments of this application. In this application, "at least one" refers to one or more, "a plurality of" refers to two or more, and "and/or" describes an association relationship between associated objects, and indicates that three relationships may exist. For example, A and/or B may indicate that only A exists, both A and B exist, and only B exists, where A and B may be singular or plural. The character "/" generally indicates an "or" relationship between associated objects. The expression "at least one of the following items (pieces)" or a similar expression means any combination of these items, including a single item (piece) or any combination of a plurality of items (pieces). For example, at least one item (piece) of a, b, or c may represent a, b, c, a and b, a and c, b and c, or a and b and c, where a, b, and c may be singular or plural. In addition, to facilitate clear descriptions of technical solutions of embodiments of this application, in embodiments of this application, words such as "first" and "second" are used to distinguish same or similar items whose functions and purposes are substantially the same, and a person skilled in the art may understand that the words such as "first" and "second" do not limit a quantity or an execution order. For example, "first" in a first chip and "second" in a second chip in embodiments of this application are merely used to distinguish between different chips. The first, the second, and the like in embodiments of this application are merely described as examples and used to distinguish between described objects, which do not indicate an order, nor indicate a particular limitation on a quantity of devices in embodiments of this application, and shall not constitute any limitation on embodiments of this application.

It should be noted that in this application, the word such as "example" or "for example" is used to represent giving an example, an illustration, or a description. Any embodiment or design scheme described as an "example" or "for example" in this application should not be explained as being more preferred or having more advantages than another embodiment or design scheme. Exactly, use of the word such as "example" or "for example" is intended to present a relative concept in a specific manner.

Currently, an operating band of 5G is a millimeter-wave band. Although the millimeter-wave band has abundant spectrum resources and a relatively wide operating bandwidth, a propagation loss of the millimeter-wave band is high. Generally, a phased array beamforming technology may be used to improve a signal gain, so as to reduce a transmission loss in a millimeter-wave communication process. In addition to the 5G millimeter-wave band, the phased array beamforming technology is increasingly widely used in fields such as indoor communication and vehicle communication.

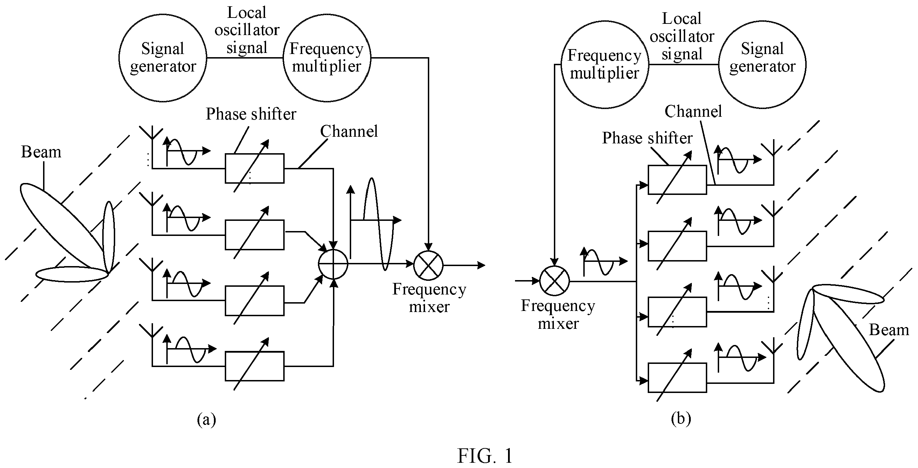

For example, in a phased array receiver shown in (a) in FIG. 1, after an antenna in the receiver receives an incident signal in a direction, a phase of each channel is controlled by a phase shifter, so that signal superposition is performed after phases of signals in the direction are aligned. This improves a signal gain in the direction. Then, a superimposed signal is input to a frequency mixer, and downmixed with a signal output by a frequency multiplier, so that the signal is shifted to a lower frequency (for example, a frequency of a baseband chip). In a phased array transmitter shown in (b) in FIG. 1, a frequency of a baseband chip may be shifted to a higher frequency by a frequency mixer, and output to a plurality of channels. Then, a phase of each channel is controlled by a phase shifter, and a phase-shifted signal is transmitted through a transmit antenna, to improve a signal gain in a fixed direction and implement beamforming.

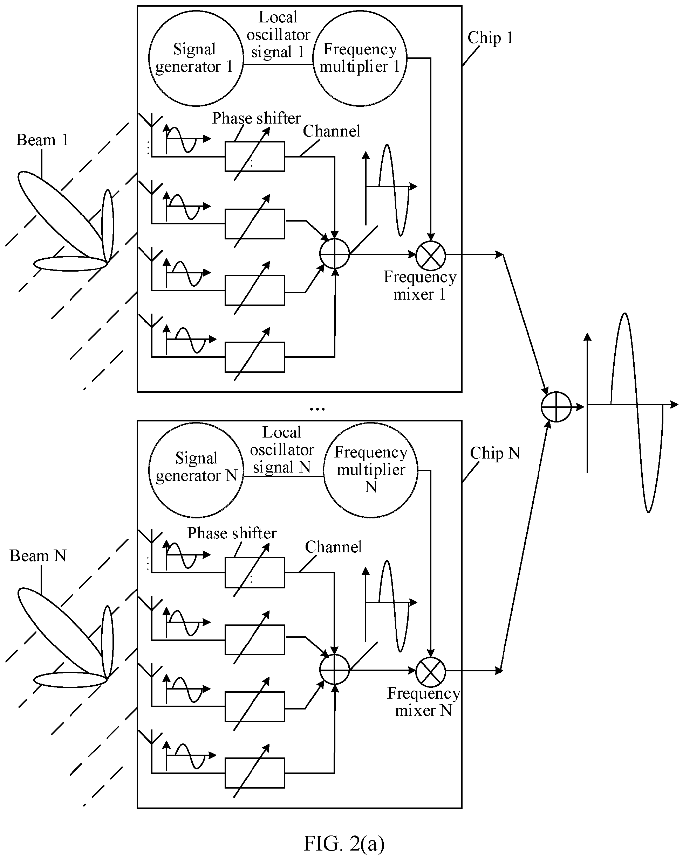

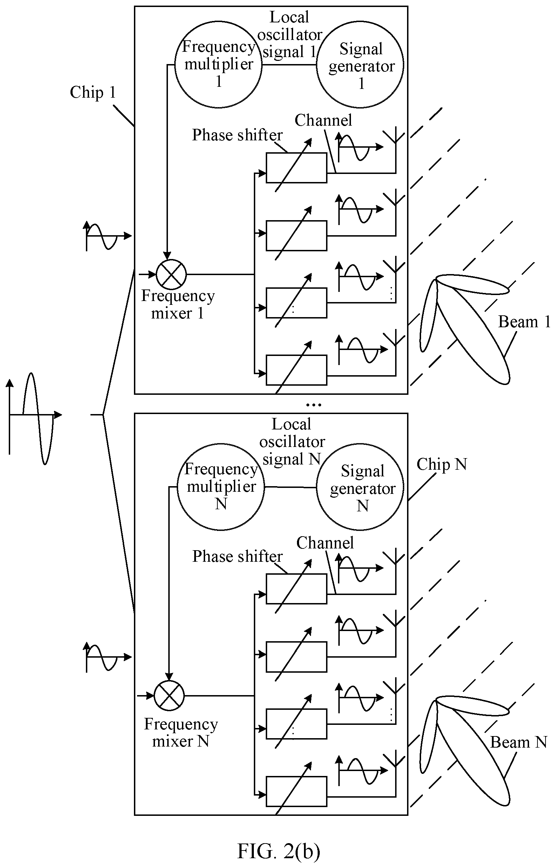

Because a signal gain is directly proportional to a quantity of channels, a larger quantity of channels indicates more phased array benefit. To obtain a higher phased array gain, a plurality of chips may be cascaded to obtain a larger quantity of channels. For example, as shown in FIG. 2A and FIG. 2B, a larger quantity of channels may be obtained by cascading a chip 1 to a chip N. After signal phases of the N chips are superimposed, a signal gain can be further improved.

Signals of different chips can be superimposed on a premise that phases, amplitudes, and frequencies of local oscillator signals of the different chips are the same. However, phases, amplitudes, and frequencies of local oscillator signals of different chips may be different. As a result, signals of the different chips cannot be superimposed. For example, as shown in FIG. 2(a) and FIG. 2(b), a local oscillator signal of each of the chip 1 to the chip N is generated by a signal generator in the chip. Local oscillator signals generated by signal generators in different chips may be asynchronous. As a result, signals of the chip 1 to the chip N cannot be superimposed. Therefore, phased array performance is limited, which affects quality of wireless communication.

To improve the phased array performance, an embodiment of this application provides a multi-chip apparatus. In the multi-chip apparatus, local oscillator signals of a plurality of chips are synchronized, so that a phased array gain can be improved, a signal transmission loss can be reduced, and quality of wireless communication can be improved.

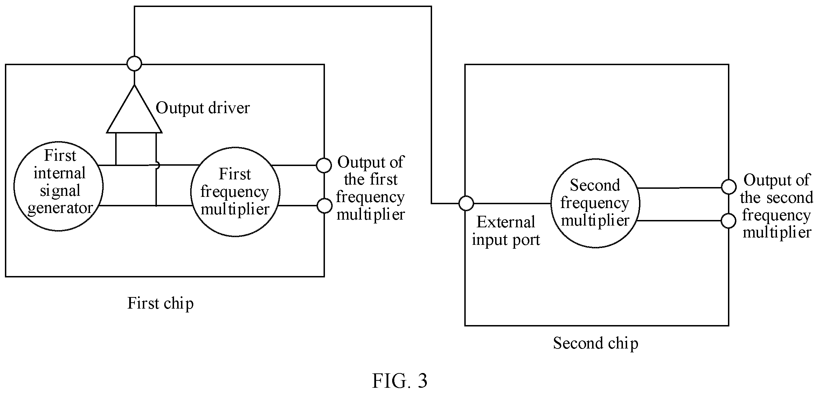

FIG. 3 shows a multi-chip apparatus according to an embodiment of this application. As shown in FIG. 3, the multi-chip apparatus includes a first chip and a second chip. The first chip includes a first internal signal generator and a first frequency multiplier coupled to the first internal signal generator. The second chip includes a second frequency multiplier, and the second frequency multiplier is coupled to the first internal signal generator through an input/output pin between the first chip and the second chip. The first internal signal generator is configured to generate a first local oscillator signal. The first frequency multiplier and the second frequency multiplier are configured to receive the first local oscillator signal, and perform frequency multiplication on the first local oscillator signal.

Optionally, the first chip may further include an output driver, the output driver is coupled to an output end of the first internal signal generator, and the output driver is configured to amplify the first local oscillator signal. The output driver may further convert the first local oscillator signal from differential signals to a single-ended signal. For example, as shown in FIG. 3, after amplified by the output driver, the first local oscillator signal generated by the first internal signal generator is input to the second frequency multiplier through an output pin of the first chip and an external input port of the second chip. For the second chip, the first local oscillator signal input to the second chip is an external input signal.

It may be understood that the first local oscillator signal generated by the first internal signal generator may be input to the first frequency multiplier, and may also be input to the second frequency multiplier through the input/output pin between the first chip and the second chip. That is, both a local oscillator signal of the first chip and a local oscillator signal of the second chip come from the first internal signal generator. Therefore, signal sources of the local oscillator signals of the first chip and the second chip are the same. When the first chip and the second chip are cascaded to form a phased array, signals of the first chip and the second chip can be superimposed, to improve a phased array gain.

The multi-chip apparatus may include one or more second chips. This is not limited in this embodiment of this application. FIG. 3 shows merely an example in which the multi-chip apparatus includes one second chip. When the multi-chip apparatus includes a plurality of second chips, the first local oscillator signal generated by the first internal signal generator may be input to each second chip through an input/output pin between the first chip and the second chip, so that signal sources of the first chip and the plurality of second chips are the same, and signals of the first chip and the plurality of second chips can be superimposed.

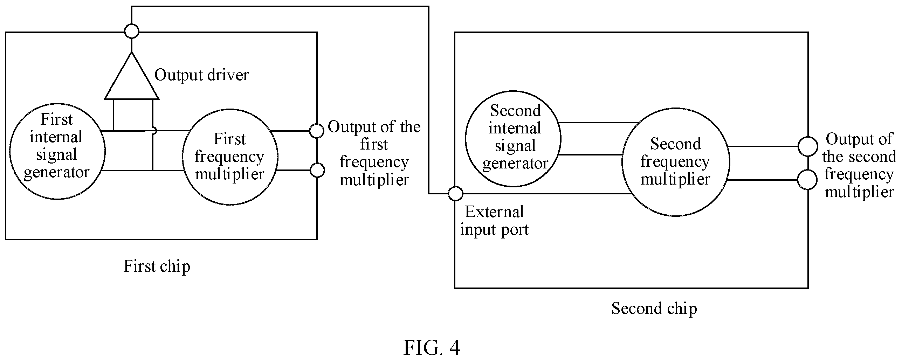

Optionally, as shown in FIG. 4, the second chip includes a second internal signal generator, and the second internal signal generator is coupled to the second frequency multiplier. The second internal signal generator is configured to generate a second local oscillator signal. The second frequency multiplier is further configured to receive the second local oscillator signal, and perform frequency multiplication on the second local oscillator signal. That is, the second frequency multiplier may receive the first local oscillator signal generated by the first internal signal generator, and may also receive the second local oscillator signal generated by the second internal signal generator. In other words, the second frequency multiplier supports both an internal signal input and an external signal input.

For example, the second frequency multiplier may include a first receiving circuit, a second receiving circuit, and a load circuit, an input end of the first receiving circuit is coupled to the first internal signal generator through the input/output pin between the first chip and the second chip, an input end of the second receiving circuit is coupled to the second internal signal generator, and an output end of the first receiving circuit and an output end of the second receiving circuit are coupled to an input end of the load circuit. The first receiving circuit is configured to receive the first local oscillator signal, and the second receiving circuit is configured to receive the second local oscillator signal. That is, the second frequency multiplier may selectively receive the first local oscillator signal and the second local oscillator signal by using the first receiving circuit and the second receiving circuit.

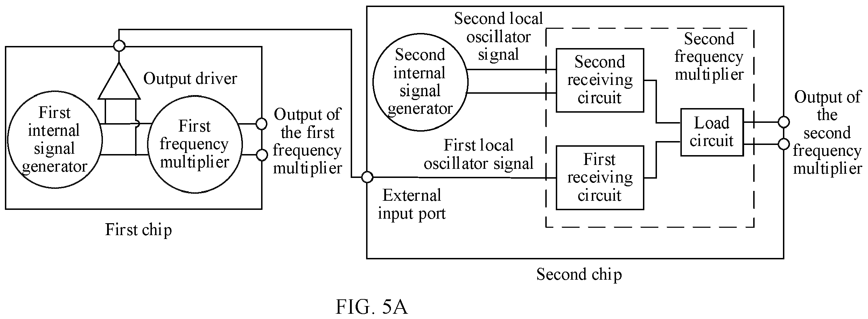

FIG. 5A is a schematic diagram of a circuit structure of a second frequency multiplier according to an embodiment of this application. As shown in FIG. 5A, an input end of a first receiving circuit may be coupled to the first internal signal generator through the output pin of the first chip and the external input end of the second chip, and is configured to receive the first local oscillator signal. An input end of a second receiving circuit is coupled to an output end of the second internal signal generator, and is configured to receive the second local oscillator signal. Both an output end of the first receiving circuit and an output end of the second receiving circuit are coupled to a load circuit. As shown in FIG. 5A, when a local oscillator signal of the second chip is the first local oscillator signal, the first receiving circuit of the second frequency multiplier receives the first local oscillator signal. When a local oscillator signal of the second chip is the second local oscillator signal, the second receiving circuit of the second frequency multiplier receives the second local oscillator signal. That is, the second frequency multiplier may not only receive, by using the first receiving circuit, the first local oscillator signal generated by the first internal signal generator, but also receive, by using the second receiving circuit, the second local oscillator signal generated by the second internal signal generator. That is, the second frequency multiplier has a capability of selectively receiving the first local oscillator signal and the second local oscillator signal.

For example, a signal output by the output end of the first receiving circuit may be a single-ended signal, or may be differential signals. A signal output by the output end of the second receiving circuit may be a single-ended signal, or may be differential signals. Whether the output ends of the first receiving circuit and the second receiving circuit output a single-ended signal or differential signals is related to a frequency multiplication principle of the second frequency multiplier and a specific structure of the load circuit. It may be understood that, when both output signals of the first receiving circuit and the second receiving circuit are single-ended signals, the load circuit has only one input end, and both the output end of the first receiving circuit and the output end of the second receiving circuit are coupled to the input end of the load circuit. When both output signals of the first receiving circuit and the second receiving circuit are differential signals, the load circuit has two input ends (that is, a pair of differential input ends), two output ends of the first receiving circuit are respectively coupled to the two input ends of the load circuit, and two output ends of the second receiving circuit are respectively coupled to the two input ends of the load circuit.

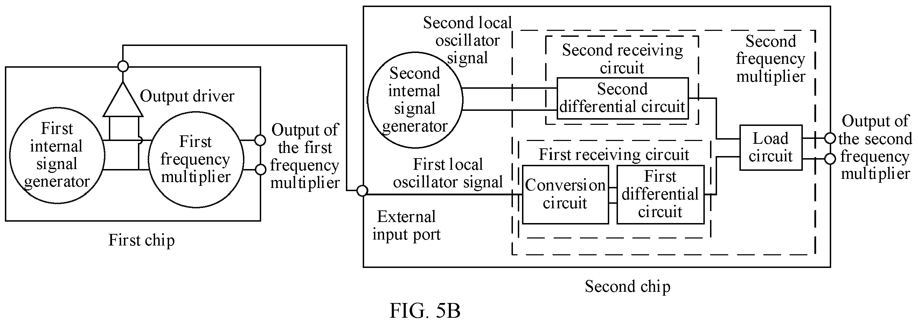

For example, as shown in FIG. 5B, the first receiving circuit includes a conversion circuit and a first differential circuit, an input end of the conversion circuit is an input end of the first receiving circuit, two output ends of the conversion circuit are respectively coupled to input ends of the first differential circuit, and output ends of the first differential circuit are output ends of the first receiving circuit. The conversion circuit is configured to convert the input first local oscillator signal into differential signals. The differential circuit is configured to receive the differential signals, and output the differential signals to the load circuit.

Optionally, the first differential circuit includes a first metal-oxide-semiconductor field-effect transistor (metal-oxide-semiconductor field-effect transistor, MOSFET) referred to as a first MOS transistor for short and a second MOS transistor. A first end of the first MOS transistor and a first end of the second MOS transistor are input ends of the first differential circuit, the first end of the first MOS transistor and the first end of the second MOS transistor are respectively coupled to the two output ends of the conversion circuit, a second end of the first MOS transistor and a second end of the second MOS transistor are grounded or connected to a first power supply, and a third end of the first MOS transistor and a third end of the second MOS transistor are output ends of the first receiving circuit.

Optionally, the first MOS transistor and the second MOS transistor may be N-type MOS transistors, or may be P-type MOS transistors. When the first MOS transistor and the second MOS transistor are NMOS transistors, the first end of the first MOS transistor is a gate, the second end of the first MOS transistor is a source, the third end of the first MOS transistor is a drain, the first end of the second MOS transistor is a gate, the second end of the second MOS transistor is a source, the third end of the second MOS transistor is a drain, and the source of the first MOS transistor and the source of the second MOS transistor are grounded. When the first MOS transistor and the second MOS transistor are PMOS transistors, the first end of the first MOS transistor is a gate, the second end of the first MOS transistor is a source, the third end of the first MOS transistor is a drain, the first end of the second MOS transistor is a gate, the second end of the second MOS transistor is a source, the third end of the second MOS transistor is a drain, and the source of the first MOS transistor and the source of the second MOS transistor are connected to the first power supply. Optionally, types of the first MOS transistor and the second MOS transistor may alternatively be different. In the following embodiment, an example in which the first MOS transistor and the second MOS transistor are NMOS transistors is used for description.

For example, the conversion circuit may include a first transformer. One end of a primary coil of the first transformer is an input end of the first receiving circuit, a second end of the primary coil of the first transformer is grounded, and two ends of a secondary coil of the first transformer are two output ends of the conversion circuit. The first transformer is configured to convert the first local oscillator signal received by the first receiving circuit into differential signals. It should be noted that a specific circuit structure of the conversion circuit is not limited in this embodiment of this application. In the following embodiment, only an example in which the conversion circuit is a transformer is used for illustration.

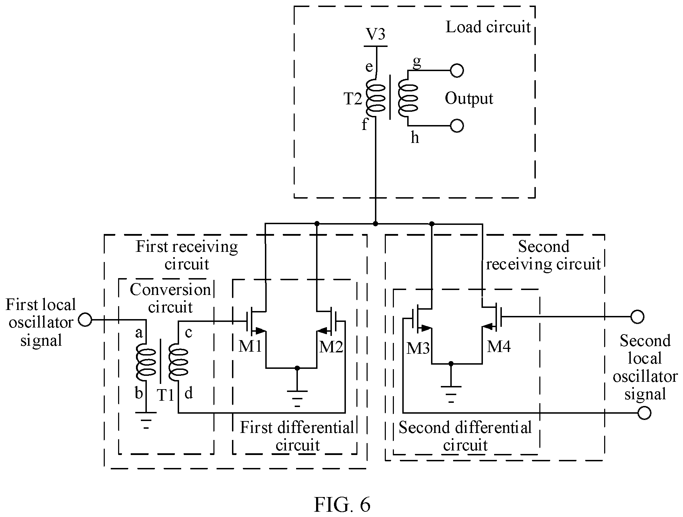

For example, FIG. 6 is a schematic diagram of a circuit structure of a second frequency multiplier according to an embodiment of this application. With reference to FIG. 5B and FIG. 6, the conversion circuit includes a first transformer T1, and the first differential circuit includes a first MOS transistor M1 and a second MOS transistor M2. One end a of a primary coil of the first transformer T1 is an input end of the first receiving circuit, the input end of the first receiving circuit is configured to input the first local oscillator signal, the other end b of the primary coil of the first transformer T1 is grounded, two ends c and d of a secondary coil of the first transformer T1 are respectively coupled to a gate of the first MOS transistor M1 and a gate of the second MOS transistor M2, a source of the first MOS transistor M1 and a source of the second MOS transistor M2 are grounded, and a drain of the first MOS transistor M1 and a drain of the second MOS transistor M2 are output ends of the first receiving circuit. In the first receiving circuit shown in FIG. 6, a signal output by the output ends of the first receiving circuit is a single-ended signal, and the drain of the first MOS transistor M1 is coupled to the drain of the second MOS transistor M2.

For example, as shown in FIG. 5B, the second receiving circuit includes a second differential circuit. The second differential circuit is configured to receive the second local oscillator signal, and output the second local oscillator signal to the load circuit.

Optionally, the second differential circuit includes a third MOS transistor and a fourth MOS transistor, a first end of the third MOS transistor and a first end of the fourth MOS transistor are two input ends of the second receiving circuit, a second end of the third MOS transistor and a second end of the fourth MOS transistor are grounded or connected to a second power supply, and a third end of the third MOS transistor and a third end of the fourth MOS transistor are output ends of the second receiving circuit.

For example, when the third MOS transistor and the fourth MOS transistor are N-type MOS transistors, the first end of the third MOS transistor is a gate, the second end of the third MOS transistor is a source, the third end of the third MOS transistor is a drain, the first end of the fourth MOS transistor is a gate, the second end of the fourth MOS transistor is a source, the third end of the fourth MOS transistor is a drain, and the source of the third MOS transistor and the source of the fourth MOS transistor are grounded. When the third MOS transistor and the fourth MOS transistor are P-type MOS transistors, the first end of the third MOS transistor is a gate, the second end of the third MOS transistor is a source, the third end of the third MOS transistor is a drain, the first end of the fourth MOS transistor is a gate, the second end of the fourth MOS transistor is a source, the third end of the fourth MOS transistor is a drain, and the source of the third MOS transistor and the source of the fourth MOS transistor are grounded. Optionally, types of the third MOS transistor and the fourth MOS transistor may alternatively be different. In the following embodiment, an example in which the third MOS transistor and the fourth MOS transistor are NMOS transistors is used for description.

For example, as shown in FIG. 6, the second differential circuit includes a third MOS transistor M3 and a fourth MOS transistor M4, a gate of the third MOS transistor M3 and a gate of the fourth MOS transistor M4 are two input ends of the second receiving circuit, and the gate of the third MOS transistor M3 and the gate of the fourth MOS transistor M4 are configured to input the first local oscillator signal. A source of the third MOS transistor M3 and a source of the fourth MOS transistor are grounded, and a drain of the third MOS transistor M3 and a drain of the fourth MOS transistor M4 are output ends of the second receiving circuit. In the second receiving circuit shown in FIG. 6, a signal output by the output ends of the second receiving circuit is a single-ended signal, and the drain of the third MOS transistor M3 is coupled to the drain of the fourth MOS transistor M4.

In a first implementation, the load circuit includes a second transformer, one end of a primary coil of the second transformer is connected to a third power supply, the other end of the primary coil of the second transformer is an input end of the load circuit, and two ends of a secondary coil of the first transformer are output ends of the load circuit.

For example, as shown in FIG. 6, one end e of a primary coil of a second transformer T2 is connected to a third power supply V3, the other end f of the primary coil of the second transformer T2 is an input end of the load circuit, and two ends g and h of a secondary coil of the first transformer are two output ends of the load circuit (that is, two output ends of the second frequency multiplier). An input signal of the load circuit shown in FIG. 6 is a single-ended signal, and the input end f of the load circuit is coupled to the output ends (the drains of M1 and M2) of the first receiving circuit and the output ends (the drains of M3 and M4) of the second receiving circuit.

As shown in FIG. 6, when a local oscillator signal of the second chip is the first local oscillator signal, M3 and M4 in the second receiving circuit are in an off state, and the first transformer T1 converts the first local oscillator signal into differential signals, and inputs the differential signals to the gates of M1 and M2 respectively. Because a pair of differential signals are input to the gates of M1 and M2, M2 is off when M1 is on, and M1 is off when M2 is on. That is, M1 and M2 may be on alternately, so that a frequency is doubled. Therefore, after the transformer T2 converts a single-ended signal into the differential signals, a double-frequency signal is output. Similarly, when a local oscillator signal of the second chip is the second local oscillator signal, M1 and M2 in the first receiving circuit are in an off state, and the second local oscillator signal is input to the gates of M3 and M4. Because a pair of differential signals are input to the gates of M3 and M4, M4 is off when M3 is on, and M3 is off when M4 is on. That is, M3 and M4 may be on alternately, so that a frequency is doubled. Therefore, after the transformer T2 converts a single-ended signal into differential signals, a double-frequency signal is output.

In a second implementation, the load circuit includes a third transformer and a fifth MOS transistor, one end of a primary coil of the third transformer is coupled to a fourth power supply and a first end of the fifth MOS transistor, the other end of the primary coil of the third transformer is coupled to a third end of the fifth MOS transistor, a second end of the fifth MOS transistor is an input end of the load circuit, and two ends of a secondary coil of the third transformer are output ends of the load circuit.

Optionally, when the fifth MOS transistor is an N-type MOS transistor, the first end of the fifth MOS transistor is a gate, the second end of the fifth MOS transistor is a source, the third end of the fifth MOS transistor is a drain, and the source of the fifth MOS transistor is grounded. When the fifth MOS transistor is a P-type MOS transistor, the first end of the fifth MOS transistor is a gate, the second end of the fifth MOS transistor is a source, the third end of the fifth MOS transistor is a drain, and the source of the fifth MOS transistor is connected to the fourth power supply. In the following embodiment, an example in which the fifth MOS transistor is an NMOS transistor is used for description.

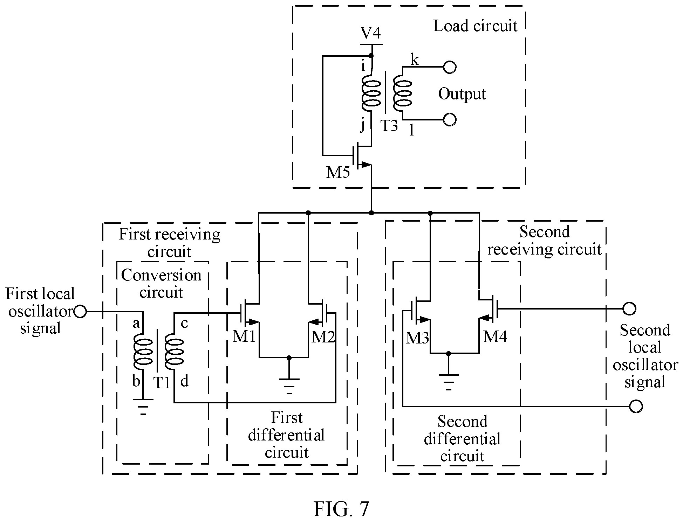

For example, FIG. 7 is a schematic diagram of a circuit structure of another second frequency multiplier according to an embodiment of this application. As shown in FIG. 7, structures of the first receiving circuit and the second receiving circuit are the same as structures of the first receiving circuit and the second receiving circuit in the second frequency multiplier shown in FIG. 6. Details are not described herein again, and only a structure of the load circuit is described.

As shown in FIG. 7, the load circuit includes a third transformer T3 and a fifth MOS transistor M5, one end i of a primary coil of the third transformer T3 is coupled to a fourth power supply V4 and a gate of the fifth MOS transistor M5, the other end j of the primary coil of the third transformer T3 is coupled to a drain of the fifth MOS transistor M5, a source of the fifth MOS transistor M5 is an input end of the load circuit, and two ends k and l of a secondary coil of the third transformer T3 are output ends of the load circuit. An input signal of the load circuit shown in FIG. 7 is a single-ended signal, and the input end (the source of M5) of the load circuit is coupled to the output ends (the drains of M1 and M2) of the first receiving circuit and the output ends (the drains of M3 and M4) of the second receiving circuit.

As shown in FIG. 7, when a local oscillator signal of the second chip is the first local oscillator signal, M3 and M4 in the second receiving circuit are in an off state, and the first transformer T1 converts the first local oscillator signal into differential signals, and inputs the differential signals to the gates of M1 and M2 respectively. Because a pair of differential signals are input to the gates of M1 and M2, M2 is off when M1 is on, and M1 is off when M2 is on. That is, M1 and M2 may be on alternately to drive the single-ended cascode transistor M5. In addition, after T3 converts a single-ended signal into differential signals, a double-frequency signal is output. Similarly, when a local oscillator signal of the second chip is the second local oscillator signal, M1 and M2 in the first receiving circuit are in an off state, and the second local oscillator signal is input to the gates of M3 and M4. Because a pair of differential signals are input to the gates of M3 and M4, M4 is off when M3 is on, and M3 is off when M4 is on. That is, M3 and M4 may be on alternately to drive the single-ended cascode transistor M5. In addition, after T3 converts a single-ended signal into differential signals, a double-frequency signal is output.

It should be noted that a frequency multiplication principle of the second frequency multiplier shown in FIG. 6 and FIG. 7 is a frequency multiplication principle of a push-push structure (push-push), differential signals are input to differential pair transistors M1 and M2 or M3 and M4, the differential pair transistors output a single-ended signal to the transformer or the single-ended cascode transistor M5, and the transformer converts the single-ended signal into differential signals to generate a double-frequency signal. A specific circuit structure of the load circuit in the second frequency multiplier when frequency multiplication is performed by using the push-push frequency doubling principle is not limited in this embodiment of this application. Herein, only an example in which the load circuit is the circuit structure shown in FIG. 6 or FIG. 7 is used for description.

Optionally, the load circuit in the second frequency multiplier may be an oscillation circuit, and a resonance frequency of the oscillation circuit may be n times a frequency of the first local oscillator signal or a frequency of the second local oscillator signal. The oscillation circuit is configured to multiply the frequency of the first local oscillator signal or the frequency of the second local oscillator signal by n. Optionally, n is an odd number greater than 1. A specific circuit structure of the oscillation circuit is not limited in this embodiment of this application. The following uses two types of oscillation circuits as examples for description.

In a third implementation, the load circuit includes a sixth MOS transistor, a seventh MOS transistor, and a first LC circuit. A first end of the sixth MOS transistor is coupled to a third end of the seventh MOS transistor, a second end of the sixth MOS transistor and a second end of the seventh MOS transistor are grounded or connected to a fifth power supply, a third end of the sixth MOS transistor is coupled to a first end of the seventh MOS transistor, and the first end of the sixth MOS transistor and the first end of the seventh MOS transistor are respectively two input ends of the load circuit. Two input ends of the first LC circuit are coupled to a sixth power supply, two output ends of the first LC circuit are respectively coupled to the third end of the sixth MOS transistor and the third end of the seventh MOS transistor, and the two output ends of the first LC circuit are output ends of the load circuit.

Optionally, when the sixth MOS transistor and the seventh MOS transistor are N-type MOS transistors, the first end of the sixth MOS transistor is a gate, the second end of the sixth MOS transistor is a source, the third end of the sixth MOS transistor is a drain, the first end of the seventh MOS transistor is a gate, the second end of the seventh MOS transistor is a source, the third end of the seventh MOS transistor is a drain, and the source of the sixth MOS transistor and the source of the seventh MOS transistor are grounded. When the sixth MOS transistor and the seventh MOS transistor are P-type MOS transistors, the first end of the sixth MOS transistor is a gate, the second end of the sixth MOS transistor is a source, the third end of the sixth MOS transistor is a drain, the first end of the seventh MOS transistor is a gate, the second end of the seventh MOS transistor is a source, the third end of the seventh MOS transistor is a drain, and the source of the sixth MOS transistor and the source of the seventh MOS transistor are connected to the fifth power supply. Optionally, types of the sixth MOS transistor and the seventh MOS transistor may be different. In the following embodiment, an example in which the sixth MOS transistor and the seventh MOS transistor are NMOS transistors is used for description.

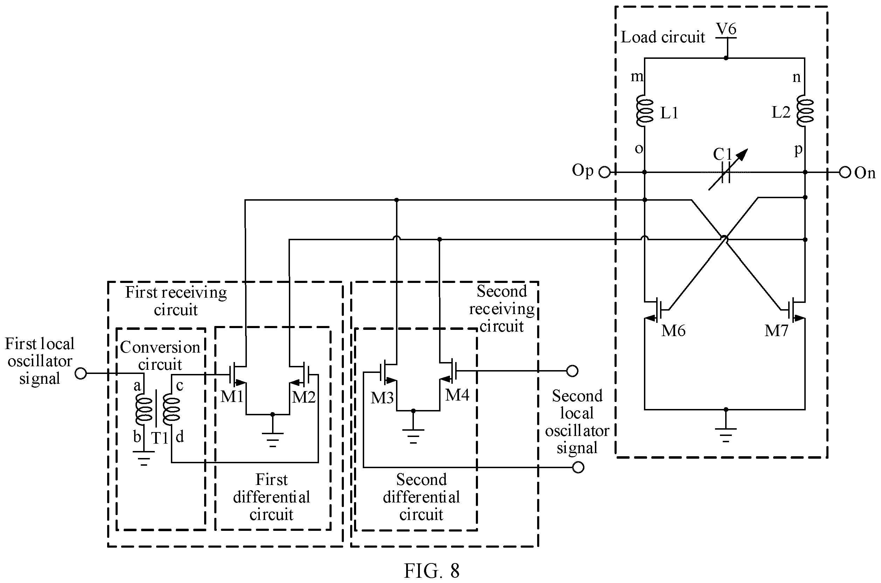

For example, FIG. 8 is a schematic diagram of a circuit structure of another second frequency multiplier according to an embodiment of this application. As shown in FIG. 8, structures of the first receiving circuit and the second receiving circuit differ from structures of the first receiving circuit and the second receiving circuit in the second frequency multiplier shown in FIG. 6 and FIG. 7 in that output signals of the first receiving circuit and the second receiving circuit in the second frequency multiplier shown in FIG. 6 and FIG. 7 are single-ended signals, while output signals of the first receiving circuit and the second receiving circuit in the second frequency multiplier shown in FIG. 8 are differential signals. As shown in FIG. 8, differential signals output by the first receiving circuit are respectively coupled to a gate of M7 and a gate of M6, and differential signals output by the second receiving circuit are respectively coupled to the gate of M7 and the gate of M6.

As shown in FIG. 8, the load circuit includes the sixth MOS transistor M6, the seventh MOS transistor M7, and a first LC circuit, and the first LC circuit includes an inductor L1, an inductor L2, and a variable capacitor C1. The gate of the sixth MOS transistor M6 is coupled to a drain of the seventh MOS transistor M7, a source of the sixth MOS transistor M6 and a source of the seventh MOS transistor M7 are grounded, a drain of the sixth MOS transistor M6 is coupled to the gate of the seventh MOS transistor M7, and the gate of the sixth MOS transistor M6 and the gate of the seventh MOS transistor are respectively two input ends of the load circuit. One end m of L1 and one end n of L2 are input ends of the first LC circuit, the one end m of L1 and the one end n of L2 are coupled to a sixth power supply V6, the other end o of L1 and the other end p of L2 are respectively coupled to the drain of the sixth MOS transistor M6 and the drain of the seventh MOS transistor M7, and the other end o of L1 is coupled to the other end p of L2 through the variable capacitor C1. The other end o of L1 and the other end p of L2 are two output ends of the first LC circuit, and the two output ends of the first LC circuit are output ends of the load circuit.

As shown in FIG. 8, when a local oscillator signal of the second chip is the first local oscillator signal, M3 and M4 in the second receiving circuit are in an off state, and the first transformer T1 converts the first local oscillator signal into differential signals, and inputs the differential signals to the gates of M1 and M2 respectively. High-order odd differential current signals generated by M1 and M2 non-linearly are injected into a negative-resistance resonant cavity including M6, M7, L1, L2, and C1. Therefore, the resonant cavity performs resonant amplification on the high-order odd signals to implement a frequency multiplication output. For example, if the second frequency multiplier is used to implement a triple-frequency output, M1 and M2 generate third harmonics non-linearly, and the third harmonics are injected into the negative-resistance resonant cavity including M6, M7, L1, L2, and C1. A resonance frequency of the resonant cavity is three times the frequency of the first local oscillator signal. The resonant cavity may perform resonant amplification on the relatively weak third harmonics, to implement a triple-frequency output. Similarly, when a local oscillator signal of the second chip is the second local oscillator signal, M1 and M2 in the first receiving circuit are in an off state, and the second local oscillator signal is input to the gates of M3 and M4. High-order odd differential current signals generated by M3 and M4 non-linearly are injected into the negative-resistance resonant cavity including M6, M7, L1, L2, and C1. Therefore, the resonant cavity performs resonant amplification on the high-order odd signals to implement a frequency multiplication output.

Optionally, the first LC circuit may be a transformer. Alternatively, the first LC circuit may include only one inductor, or include only one inductor and one capacitor. It should be noted that a specific circuit structure of the first LC circuit is not limited in this embodiment of this application. In FIG. 8, only an example in which the first LC circuit includes two inductors L1 and L2 and one variable capacitor C1 is used for description.

In a fourth implementation, the load circuit includes an eighth MOS transistor, a ninth MOS transistor, and a second LC circuit. A first end of the eighth MOS transistor is coupled to a third end of the ninth MOS transistor, a third end of the eighth MOS transistor is coupled to a first end of the ninth MOS transistor, and a second end of the eighth MOS transistor and a second end of the ninth MOS transistor are respectively two input ends of the load circuit. Two input ends of the second LC circuit are coupled to a seventh power supply, two output ends of the second LC circuit are respectively coupled to the third end of the eighth MOS transistor and the third end of the ninth MOS transistor, and the two output ends of the second LC circuit are output ends of the load circuit.

Optionally, when the eighth MOS transistor and the ninth MOS transistor are N-type MOS transistors, the first end of the eighth MOS transistor is a gate, the second end of the eighth MOS transistor is a source, the third end of the eighth MOS transistor is a drain, the first end of the ninth MOS transistor is a gate, the second end of the ninth MOS transistor is a source, the third end of the ninth MOS transistor is a drain, and the source of the eighth MOS transistor and the source of the ninth MOS transistor are grounded. When the eighth MOS transistor and the ninth MOS transistor are P-type MOS transistors, the first end of the eighth MOS transistor is a gate, the second end of the eighth MOS transistor is a source, the third end of the eighth MOS transistor is a drain, the first end of the ninth MOS transistor is a gate, the second end of the ninth MOS transistor is a source, the third end of the ninth MOS transistor is a drain, and the source of the eighth MOS transistor and the source of the ninth MOS transistor are connected to the seventh power supply. Optionally, types of the eighth MOS transistor and the ninth MOS transistor may be different. In the following embodiment, an example in which the eighth MOS transistor and the ninth MOS transistor are NMOS transistors is used for description.

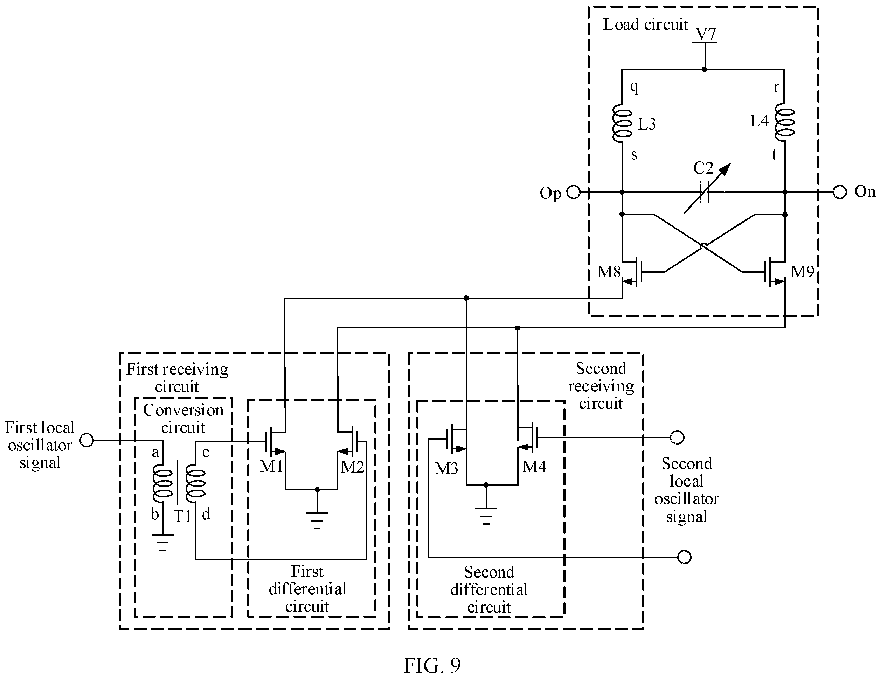

For example, FIG. 9 is a schematic diagram of a circuit structure of another second frequency multiplier according to an embodiment of this application. As shown in FIG. 9, structures of the first receiving circuit and the second receiving circuit differ from those of the first receiving circuit and the second receiving circuit in the second frequency multiplier shown in FIG. 6 and FIG. 7 in that output signals of the first receiving circuit and the second receiving circuit in the second frequency multiplier shown in FIG. 6 and FIG. 7 are single-ended signals, while output signals of the first receiving circuit and the second receiving circuit in the second frequency multiplier shown in FIG. 9 are differential signals. As shown in FIG. 9, differential signals output by the first receiving circuit are respectively coupled to a source of M8 and a source of M9, and differential signals output by the second receiving circuit are respectively coupled to the source of M8 and the source of M9.

As shown in FIG. 9, the load circuit includes the eighth MOS transistor M8, the ninth MOS transistor M9, and a second LC circuit, and the second LC circuit includes a variable capacitor C2 and a pair of differential inductors including an inductor L3 and an inductor L4. A gate of the eighth MOS transistor M8 is coupled to a drain of the ninth MOS transistor M9, a drain of the eighth MOS transistor M8 is coupled to a gate of the ninth MOS transistor M9, and the source of the eighth MOS transistor M8 and the source of the ninth MOS transistor M9 are respectively two input ends of the load circuit. One end q of L3 and one end r of L4 are input ends of the second LC circuit, the one end q of L3 and the one end r of L4 are coupled to a seventh power supply V7, the other end s of L3 and the other end t of L4 are respectively coupled to the drain of the eighth MOS transistor M8 and the drain of the ninth MOS transistor M9, and the other end s of L3 is coupled to the other end t of L4 through the variable capacitor C2. The other end s of L3 and the other end t of L4 are two output ends of the second LC circuit, and the two output ends of the second LC circuit are output ends of the load circuit.

As shown in FIG. 9, when a local oscillator signal of the second chip is the first local oscillator signal, M3 and M4 in the second receiving circuit are in an off state, and the first transformer T1 converts the first local oscillator signal into differential signals, and inputs the differential signals to the gates of M1 and M2 respectively. High-order odd differential current signals generated by M1 and M2 non-linearly are injected into a negative-resistance resonant cavity including M8, M9, L3, L4, and C2. Therefore, the resonant cavity performs resonant amplification on the high-order odd signals to implement a frequency multiplication output. For example, if the second frequency multiplier is used to implement a triple-frequency output, M1 and M2 generate third harmonics non-linearly, and the third harmonics are injected into the negative-resistance resonant cavity including M8, M9, L3, L4, and C2. A resonance frequency of the resonant cavity is three times the frequency of the first local oscillator signal. The resonant cavity may perform resonant amplification on the relatively weak third harmonics, to implement a triple-frequency output. Similarly, when a local oscillator signal of the second chip is the second local oscillator signal, M1 and M2 in the first receiving circuit are in an off state, and the second local oscillator signal is input to the gates of M3 and M4. High-order odd differential current signals generated by M3 and M4 non-linearly are injected into the negative-resistance resonant cavity including M8, M9, L3, L4, and C2. Therefore, the resonant cavity performs resonant amplification on the high-order odd signals to implement a frequency multiplication output. It should be noted that, a difference between the second frequency multiplier shown in FIG. 9 and the second frequency multiplier shown in FIG. 8 lies in different differential current injection points. Differential current injection points of the second frequency multiplier shown in FIG. 8 are the gates of M6 and M7, while differential current injection points of the second frequency multiplier shown in FIG. 9 are the sources of M8 and M9.

Optionally, the second LC circuit may be a transformer. Alternatively, the second LC circuit may include only one inductor, or may include only one inductor and one capacitor, or may include a plurality of inductors or capacitors. It should be noted that a specific circuit structure of the second LC circuit is not limited in this embodiment of this application. In FIG. 9, only an example in which the second LC circuit includes two inductors L3 and L4 and one variable capacitor C2 is used for description.

It should be noted that, a frequency multiplication structure of the second frequency multiplier shown in FIG. 8 and FIG. 9 is an injection locking structure (injection locking), high-order odd differential current signals generated by differential pair transistors non-linearly are injected into a negative-resistance resonant cavity, and the resonant cavity performs resonant amplification on the high-order odd signals to implement a frequency multiplication output. A specific circuit structure of the load circuit in the second frequency multiplier when frequency multiplication is performed by using the injection locking structure is not limited in this embodiment of this application. Herein, only an example in which the load circuit is the oscillation circuit shown in FIG. 8 or FIG. 9 is used for description.

The second frequency multiplier shown in FIG. 6 to FIG. 9 not only has a function of selecting an internal signal input or an external signal input, but also has a frequency multiplication function. Therefore, when using the frequency multiplier, the chip can have a relatively small area and relatively low power consumption.

Optionally, when the second frequency multiplier has only the frequency multiplication function but does not have the selection function, the second chip may further include a selector, the second internal signal generator is coupled to the second frequency multiplier through the selector, and the second frequency multiplier selectively receives the first local oscillator signal and the second local oscillator signal through the selector.

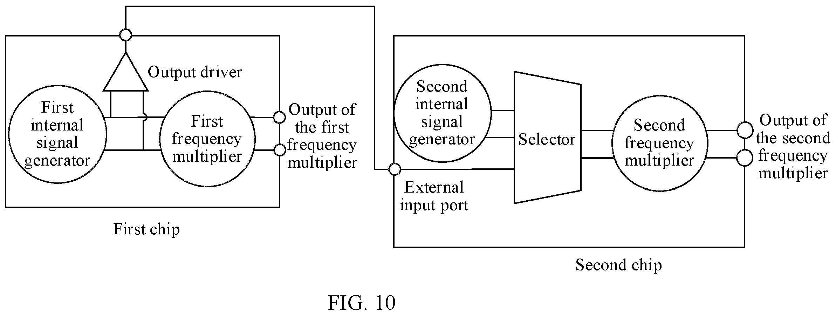

For example, as shown in FIG. 10, input ends of the selector are coupled to the first internal signal generator and the second internal signal generator, and the second frequency multiplier selectively receives the first local oscillator signal and the second local oscillator signal through the selector.

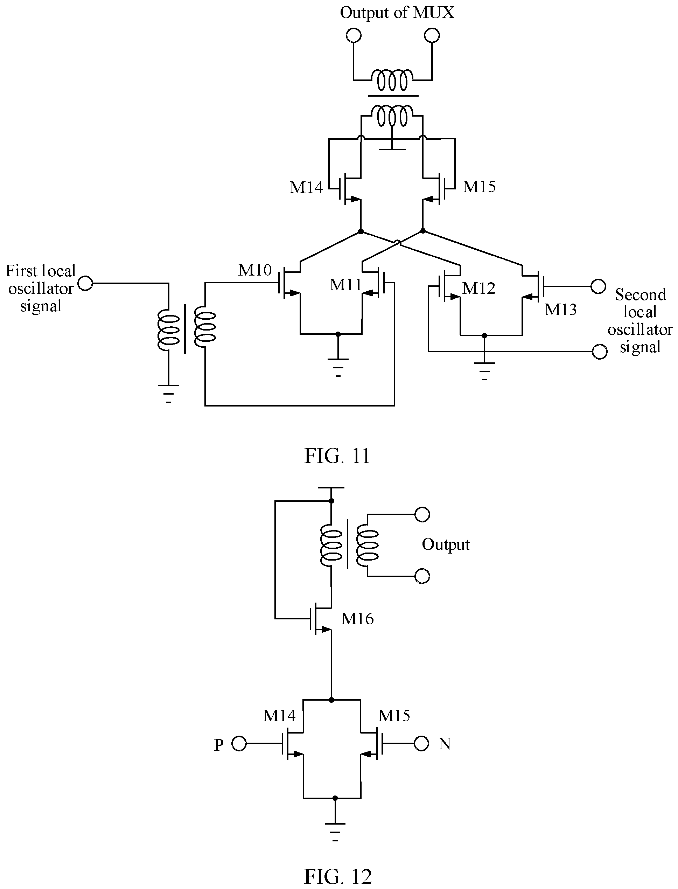

For example, FIG. 11 is a schematic diagram of a circuit structure of a multiplexer (multiplexer, MUX). As shown in FIG. 11, one input port of the selector is an internal signal input port, and is configured to receive the first local oscillator signal. Another input port of the selector is an external signal input port, and is configured to receive the second local oscillator signal. The first local oscillator signal is converted into differential signals by a transformer, to drive a group of differential common-source transistors M10/M11. The second local oscillator signal may drive another group of differential common-source transistors M12/M13. The two groups of common-source amplifier transistors are connected to differential cascode amplifier transistors M14/M15, and differential signals are output to a next-stage frequency multiplier circuit through a transformer.

As shown in FIG. 11, the selector supports two operating modes: internal signal inputting and external signal inputting. An input of a first operating mode is the first local oscillator signal (external signal input), M12 and M13 are off, M10/M11 is on, and the first local oscillator signal is used as a signal source to drive the differential common-source transistors M10/M11, and is output to the next-stage frequency multiplier. An input of the second operating mode is the second local oscillator signal (internal signal input), M10 and M11 are off, M12/M13 is on, and the second local oscillator signal is used as a signal source to drive the differential common-source transistors M12/M13, and is output to the next-stage frequency multiplier.

For example, FIG. 12 is a schematic diagram of a circuit structure of a frequency multiplier. As shown in FIG. 12, two output ends of the selector are respectively coupled to two input ends P and N of the frequency multiplier, and differential signals are input to gates of M14 and M15, and output by drains of M14 and M15 to a single-ended cascode transistor M16, and a transformer converts a single-ended signal into differential outputs to generate a double-frequency signal.

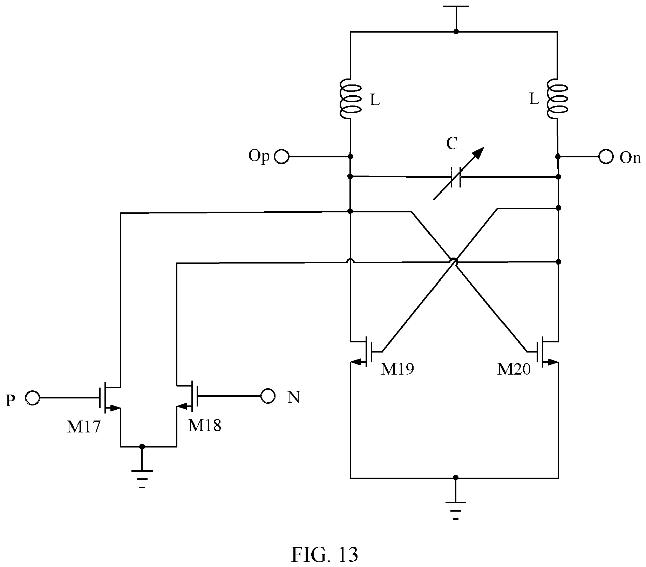

For example, FIG. 13 is a schematic diagram of a circuit structure of another frequency multiplier. As shown in FIG. 13, two output ends of the selector are respectively coupled to two input ends P and N of the frequency multiplier, and input signals are input to gates of M17 and M18. High-order odd differential current signals generated by M17 and M18 non-linearly are injected into a negative-resistance resonant cavity including M19, M20, and an LC circuit. Therefore, the resonant cavity performs resonant amplification on the high-order odd signals to implement a frequency multiplication output.

Specific circuit structures of the selector and the frequency multiplier are not limited in this embodiment of this application. Herein, only an example in which the selector is the circuit structure shown in FIG. 11 and the frequency multiplier is the circuit structure shown in FIG. 12 or FIG. 13 is used for illustration.

It should be noted that, a difference between the structure of the second chip shown in FIG. 5A or FIG. 5B and the structure of the second chip shown in FIG. 10 lies in that the second frequency multiplier shown in FIG. 5A or FIG. 5B includes the first receiving circuit and the second receiving circuit, and the second frequency multiplier may selectively receive the first local oscillator signal (external signal) and the second local oscillator signal (internal signal) by using the first receiving circuit and the second receiving circuit. Therefore, the second frequency multiplier shown in FIG. 5A or FIG. 5B has a selection function and a frequency multiplication function. Therefore, no additional selector is needed. The second frequency multiplier shown in FIG. 10 does not have a selection function. Therefore, a selector needs to be disposed, and an internal signal or an external signal is selectively input to the second frequency multiplier through the selector.

For example, the second frequency multiplier shown in FIG. 6 to FIG. 9 includes the first receiving circuit and the second receiving circuit. With the two receiving circuits, the second frequency multiplier may selectively receive the first local oscillator signal and the second local oscillator signal. The second frequency multiplier shown in FIG. 12 and FIG. 13 does not have a selection function, and the first local oscillator signal and the second local oscillator signal need to be selectively received through the selector shown in FIG. 11. It may be understood that, when the second frequency multiplier shown in FIG. 12 and FIG. 13 is used, the second chip includes both the second frequency multiplier and the selector, that is, the second chip needs to include two stages of circuits to support the two operating modes: external signal inputting and internal signal inputting, and implement frequency multiplication. In this implementation, the chip has a relatively large area and relatively high power consumption. When the second frequency multiplier shown in FIG. 6 to FIG. 9 is used, only one stage of circuit is needed to support the two operating modes and implement frequency multiplication. Therefore, an area of the chip is reduced, and power consumption is reduced. In addition, compared with the selector shown in FIG. 11 and the second frequency multiplier shown in FIG. 12 or FIG. 13, the second frequency multiplier shown in any one of FIG. 6 to FIG. 9 combines the selection function and the frequency multiplication function, so that no additional transformer is needed, and an area of a stage of transformer coil is saved.

Optionally, for a circuit structure of the first frequency multiplier, refer to the circuit structure of the second frequency multiplier. Details are not described herein again. When the circuit structure of the first frequency multiplier is the circuit structure shown in any one of FIG. 6 to FIG. 9, the first chip has a relatively small area and relatively low power consumption.

Optionally, the multi-chip apparatus may further include a power splitter, the power splitter includes a first output end and a second output end, an input end of the power splitter is coupled to the output end of the first internal signal generator, and the first output end and the second output end of the power splitter are respectively coupled to the first frequency multiplier and the second frequency multiplier. The first internal signal generator may output the first local oscillator signal to the first chip and the second chip through the power splitter.

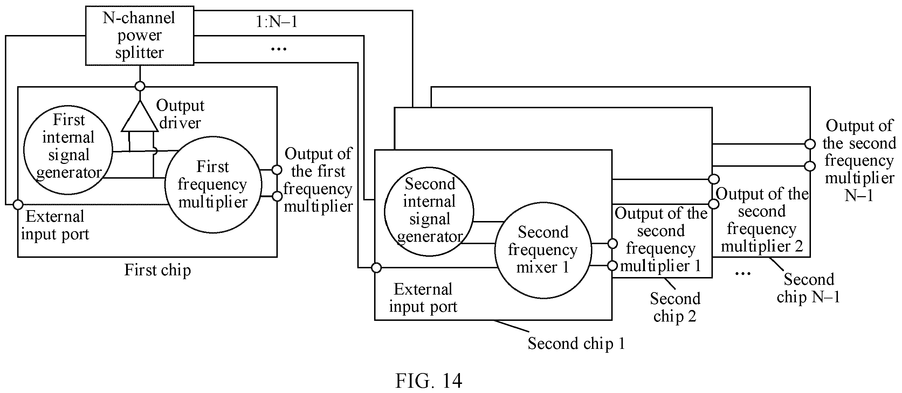

For example, as shown in FIG. 14, the power splitter is an N-channel power splitter, the multi-chip apparatus includes the N-channel power splitter, one first chip, and N-1 second chips. The N-channel power splitter includes N output ends, one output end of the N-channel power splitter is coupled to an external input port of the first chip, and the other N-1 output ends of the N-channel power splitter are respectively coupled to a second frequency multiplier 1 to a second frequency multiplier N-1 through external input ports of the N-1 second chips.

It may be understood that in the multi-chip apparatus shown in FIG. 3 to FIG. 5A, a signal path of a first local oscillator signal input to the first frequency multiplier is different from that of a first local oscillator signal input to the second frequency multiplier. For example, after generated by the first internal signal generator, the first local oscillator signal input to the second chip is input to the second frequency multiplier through the output driver of the first chip and the external input port of the second chip, while the first local oscillator signal input to the first frequency multiplier is directly input to the first frequency multiplier after generated by the first internal signal generator. As a result, a phase of the first local oscillator signal input to the first frequency multiplier may be different from that of the second local oscillator signal input to the second frequency multiplier, and an additional circuit is further needed to correct the phases of the local oscillator signals, so that the phases of the local oscillator signals of the first chip and the second chip are aligned. In the multi-chip apparatus shown in FIG. 14, the power splitter is disposed, and the first local oscillator signal generated by the first internal signal generator is output to the external input ends of the first chip and the second chip through the power splitter, so that a signal path of a local oscillator signal input to the first frequency multiplier is exactly the same as that of a local oscillator signal input to the second frequency multiplier. Therefore, a phase, an amplitude, and a frequency of the local oscillator signal of the first chip are all the same as those of the local oscillator signal of the second chip, and phase alignment between the first chip and the second chip can be ensured without an additional correction circuit.

Optionally, circuit structures of the first chip and the second chip in the multi-chip apparatus shown in FIG. 3 to FIG. 5A and FIG. 14 may be the same. For example, the second chip may also output the second frequency multiplication signal generated by the second internal signal generator of the second chip to another chip through an output driver.

In the multi-chip apparatus provided in this embodiment of this application, because both a local oscillator signal of the first chip and a local oscillator signal of the second chip come from the first internal signal generator, the local oscillator signals of the first chip and the second chip are synchronized. Therefore, when the first chip and the second chip are cascaded to form a phased array, signals of the first chip and the second chip can be superimposed, to improve a phased array gain and reduce a signal transmission loss.

Optionally, the first chip may further include a plurality of first phased array channels and a first frequency mixer, and the plurality of first phased array channels are coupled to the first frequency multiplier through the first frequency mixer. The second chip may further include a plurality of second phased array channels and a second frequency mixer, and the plurality of second phased array channels are coupled to the second frequency multiplier through the second frequency mixer.

An embodiment of this application further provides a frequency multiplier. The frequency multiplier includes a first receiving circuit, a second receiving circuit, and a load circuit, an input end of the first receiving circuit is configured to receive a first local oscillator signal, an input end of the second receiving circuit is configured to receive a second local oscillator signal, and an output end of the first receiving circuit and an output end of the second receiving circuit are coupled to an input end of the load circuit. For specific circuit structures of the first receiving circuit, the second receiving circuit, and the load circuit, refer to the foregoing embodiment. Details are not described herein again. Because the frequency multiplier provided in this embodiment of this application may respectively receive the first local oscillator signal and the second local oscillator signal by using the first receiving circuit and the second receiving circuit, selection and frequency multiplication functions can be implemented without disposing an additional selector, thereby reducing an area of a chip and reducing power consumption of the chip.

An embodiment of this application further provides a communication apparatus. The communication apparatus includes the first chip in any one of the foregoing embodiments, the second chip in any one of the foregoing embodiments, a plurality of first antenna units, and a plurality of second antenna units. The plurality of first antenna units are coupled to the plurality of first phased array channels one by one, and the plurality of second antenna units are coupled to the plurality of second phased array channels one by one.

An embodiment of this application further provides an electronic device. The electronic device includes a baseband chip and a multi-chip apparatus. For a structure of the multi-chip apparatus, refer to the foregoing embodiment. Details are not described herein again.

Method or algorithm steps described with reference to the content disclosed in this application may be implemented by hardware, or may be implemented by a processor by executing a software instruction. The software instruction may include a corresponding software module. The software module may be stored in a random access memory (Random Access Memory, RAM), a flash memory, an erasable programmable read-only memory (Erasable Programmable ROM, EPROM), an electrically erasable programmable read-only memory (Electrically EPROM, EEPROM), a register, a hard disk, a removable hard disk, a compact disc read-only memory (CD-ROM), or a storage medium in any other form well known in the art. For example, the storage medium is coupled to the processor, so that the processor can read information from the storage medium or write information into the storage medium. Certainly, the storage medium may alternatively be a component of the processor. The processor and the storage medium may be located in an ASIC. In addition, the ASIC may be located in a core network interface device. Certainly, the processor and the storage medium may alternatively exist in the core network interface device as discrete components.

A person skilled in the art should be aware that in one or more of the foregoing examples, functions described in the present invention may be implemented by using hardware, software, firmware, or any combination thereof. When the functions are implemented by using software, these functions may be stored in a computer-readable medium or transmitted as one or more instructions or code in the computer-readable medium. The computer-readable medium includes a computer storage medium and a communication medium. The communication medium includes any medium that enables a computer program to be transmitted from one place to another. The storage medium may be any available medium accessible to a general-purpose or dedicated computer.

Objectives, technical solutions, and beneficial effects of the present invention are further described in detail in the foregoing specific implementations. It should be understood that the foregoing descriptions are merely specific implementations of the present invention, and are not intended to limit the protection scope of the present invention. Any modification, equivalent replacement, improvement, or the like made based on the technical solutions of the present invention shall fall within the protection scope of the present invention.

## Claims

1. A multi-chip apparatus, wherein the multi-chip apparatus comprises a first chip and a second chip, the first chip comprises a first internal signal generator and a first frequency multiplier coupled to the first internal signal generator, and the second chip comprises a second internal signal generator and a second frequency multiplier coupled to the second internal signal generator; and the second frequency multiplier comprises a first receiving circuit, a second receiving circuit, and a load circuit, an input end of the first receiving circuit is coupled to an output end of the first internal signal generator through an input/output pin between the first chip and the second chip, an input end of the second receiving circuit is coupled to an output end of the second internal signal generator, and an output end of the first receiving circuit and an output end of the second receiving circuit are coupled to an input end of the load circuit, wherein
the first internal signal generator is configured to generate a first local oscillator signal;
the first frequency multiplier is configured to receive the first local oscillator signal, and perform frequency multiplication on the first local oscillator signal;
the second internal signal generator is configured to generate a second local oscillator signal; and
the second frequency multiplier is configured to receive the first local oscillator signal by using the first receiving circuit, receive the second local oscillator signal by using the second receiving circuit, and perform frequency multiplication on the first local oscillator signal or the second local oscillator signal.

2. The multi-chip apparatus according to claim 1, wherein the multi-chip apparatus further comprises a power splitter, the power splitter comprises a first output end and a second output end, and an input end of the power splitter is coupled to the output end of the first internal signal generator, and the first output end and the second output end of the power splitter are respectively coupled to the first frequency multiplier and the second frequency multiplier.

3. The multi-chip apparatus according to claim 1 or 2, wherein the first chip further comprises an output driver, the output driver is coupled to the output end of the first internal signal generator, and the output driver is configured to amplify the first local oscillator signal.

4. The multi-chip apparatus according to any one of claims 1 to 3, wherein the first receiving circuit comprises a conversion circuit and a first differential circuit, an input end of the conversion circuit is an input end of the first receiving circuit, two output ends of the conversion circuit are respectively coupled to input ends of the first differential circuit, and output ends of the first differential circuit are output ends of the first receiving circuit;
the conversion circuit is configured to convert the input first local oscillator signal into differential signals; and
the differential circuit is configured to receive the differential signals, and output the differential signals to the load circuit.

5. The multi-chip apparatus according to claim 4, wherein the first differential circuit comprises a first metal-oxide-semiconductor MOS transistor and a second MOS transistor, a first end of the first MOS transistor and a first end of the second MOS transistor are input ends of the first differential circuit, a second end of the first MOS transistor and a second end of the second MOS transistor are grounded or connected to a first power supply, and a third end of the first MOS transistor and a third end of the second MOS transistor are output ends of the first receiving circuit.

6. The multi-chip apparatus according to claim 5, wherein the first MOS transistor and the second MOS transistor are N-type MOS transistors, the first end of the first MOS transistor is a gate, the second end of the first MOS transistor is a source, the third end of the first MOS transistor is a drain, the first end of the second MOS transistor is a gate, the second end of the second MOS transistor is a source, the third end of the second MOS transistor is a drain, and the source of the first MOS transistor and the source of the second MOS transistor are grounded.

7. The multi-chip apparatus according to any one of claims 4 to 6, wherein the conversion circuit comprises a first transformer, one end of a primary coil of the first transformer is an input end of the first receiving circuit, a second end of the primary coil of the first transformer is grounded, and two ends of a secondary coil of the first transformer are two output ends of the conversion circuit.

8. The multi-chip apparatus according to any one of claims 1 to 7, wherein the second receiving circuit comprises a second differential circuit, and the second differential circuit is configured to receive the second local oscillator signal, and output the second local oscillator signal to the load circuit.

9. The multi-chip apparatus according to claim 8, wherein the second differential circuit comprises a third MOS transistor and a fourth MOS transistor, a first end of the third MOS transistor and a first end of the fourth MOS transistor are two input ends of the second receiving circuit, a second end of the third MOS transistor and a second end of the fourth MOS transistor are grounded or connected to a second power supply, and a third end of the third MOS transistor and a third end of the fourth MOS transistor are output ends of the second receiving circuit.

10. The multi-chip apparatus according to claim 9, wherein the third MOS transistor and the fourth MOS transistor are N-type MOS transistors, the first end of the third MOS transistor is a gate, the second end of the third MOS transistor is a source, the third end of the third MOS transistor is a drain, the first end of the fourth MOS transistor is a gate, the second end of the fourth MOS transistor is a source, the third end of the fourth MOS transistor is a drain, and the source of the third MOS transistor and the source of the fourth MOS transistor are grounded.

11. The multi-chip apparatus according to any one of claims 1 to 10, wherein the load circuit comprises a second transformer, one end of a primary coil of the second transformer is connected to a third power supply, the other end of the primary coil of the second transformer is an input end of the load circuit, and two ends of a secondary coil of the second transformer are output ends of the load circuit.

12. The multi-chip apparatus according to any one of claims 1 to 10, wherein the load circuit comprises a third transformer and a fifth MOS transistor, one end of a primary coil of the third transformer is coupled to a fourth power supply and a first end of the fifth MOS transistor, the other end of the primary coil of the third transformer is coupled to a third end of the fifth MOS transistor, a second end of the fifth MOS transistor is an input end of the load circuit, and two ends of a secondary coil of the third transformer are output ends of the load circuit.

13. The multi-chip apparatus according to claim 12, wherein the fifth MOS transistor is an N-type MOS transistor, the first end of the fifth MOS transistor is a gate, the second end of the fifth MOS transistor is a source, the third end of the fifth MOS transistor is a drain, and the source of the fifth MOS transistor is grounded.

14. The multi-chip apparatus according to any one of claims 1 to 10, wherein the load circuit comprises a sixth MOS transistor, a seventh MOS transistor, and a first LC circuit, a first end of the sixth MOS transistor is coupled to a third end of the seventh MOS transistor, a second end of the sixth MOS transistor and a second end of the seventh MOS transistor are grounded or connected to a fifth power supply, a third end of the sixth MOS transistor is coupled to a first end of the seventh MOS transistor, and the first end of the sixth MOS transistor and the first end of the seventh MOS transistor are respectively two input ends of the load circuit; and two input ends of the first LC circuit are coupled to a sixth power supply, two output ends of the first LC circuit are respectively coupled to the third end of the sixth MOS transistor and the third end of the seventh MOS transistor, and the two output ends of the first LC circuit are output ends of the load circuit.

15. The multi-chip apparatus according to claim 14, wherein the sixth MOS transistor and the seventh MOS transistor are N-type MOS transistors, the first end of the sixth MOS transistor is a gate, the second end of the sixth MOS transistor is a source, the third end of the sixth MOS transistor is a drain, the first end of the seventh MOS transistor is a gate, the second end of the seventh MOS transistor is a source, the third end of the seventh MOS transistor is a drain, and the source of the sixth MOS transistor and the source of the seventh MOS transistor are grounded.

16. The multi-chip apparatus according to any one of claims 1 to 10, wherein the load circuit comprises an eighth MOS transistor, a ninth MOS transistor, and a second LC circuit, a first end of the eighth MOS transistor is coupled to a third end of the ninth MOS transistor, a third end of the eighth MOS transistor is coupled to a first end of the ninth MOS transistor, and a second end of the eighth MOS transistor and a second end of the ninth MOS transistor are respectively two input ends of the load circuit; and two input ends of the second LC circuit are coupled to a seventh power supply, two output ends of the second LC circuit are respectively coupled to the third end of the eighth MOS transistor and the third end of the ninth MOS transistor, and the two output ends of the second LC circuit are output ends of the load circuit.

17. The multi-chip apparatus according to claim 16, wherein the eighth MOS transistor and the ninth MOS transistor are N-type MOS transistors, the first end of the eighth MOS transistor is a gate, the second end of the eighth MOS transistor is a source, the third end of the eighth MOS transistor is a drain, the first end of the ninth MOS transistor is a gate, the second end of the ninth MOS transistor is a source, the third end of the ninth MOS transistor is a drain, and the source of the eighth MOS transistor and the source of the ninth MOS transistor are grounded.

18. The multi-chip apparatus according to any one of claims 1 to 17, wherein the first chip further comprises a plurality of first phased array channels and a first frequency mixer, and the plurality of first phased array channels are coupled to the first frequency multiplier through the first frequency mixer; and the second chip further comprises a plurality of second phased array channels and a second frequency mixer, and the plurality of second phased array channels are coupled to the second frequency multiplier through the second frequency mixer.

19. A communication apparatus, wherein the communication apparatus comprises the first chip according to any one of claims 1 to 18, the second chip according to any one of claims 1 to 18, a plurality of first antenna units, and a plurality of second antenna units; and the plurality of first antenna units are coupled to the plurality of first phased array channels one by one, and the plurality of second antenna units are coupled to the plurality of second phased array channels one by one.

20. An electronic device, wherein the electronic device comprises a baseband chip and the multi-chip apparatus according to any one of claims 1 to 18.
